# EUROPÄISCHE PATENTSCHRIFT

(11) **EP 3 576 063 B1**
(45) Veröffentlichungstag und Bekanntmachung des Hinweises auf die Patenterteilung: **15.07.2026**
(21) Anmeldenummer: 19182589.2
(22) Anmeldetag: 13.08.2015
(51) Int. Cl.: G08B 17/103, H05B 45/12, H10F 55/15, H10F 55/25, H10W 90/00, G08B 17/107, H10W 74/00

(54) **RAUCHDETEKTIONSEINHEIT MIT LEUCHTDIODE UND PHOTOEMPFÄNGER, UND MIT EINEM IN DER LEUCHTDIODE ANGEORDNETEN LED-CHIP UND PHOTOSENSOR ZUR BESTIMMUNG EINES ALTERUNGSGRADS UND/ODER EINES LICHTSTROMKOMPENSATIONSWERTS, SOWIE EINE LEUCHTDIODE**
SMOKE DETECTOR UNIT WITH LED AND PHOTORECEIVER, LED CHIP IN THE LED AND PHOTOSENSOR FOR DETERMINING AGEING AND/OR A LIGHT BEAM COMPENSATION LEVEL, AND LED
UNITÉ DE DÉTECTION DE FUMÉE DOTÉE D'UNE DIODE ÉLECTROLUMINESCENTE ET D'UN PHOTODÉTECTEUR, ET D'UNE PUCE DEL ET D'UN PHOTO-CAPTEUR DISPOSÉS DANS LA DIODE ÉLECTROLUMINESCENTE DESTINÉS À LA DÉTERMINATION D'UN DEGRÉ DE VIEILLISSEMENT ET/OU D'UNE VALEUR DE COMPENSATION DE FLUX LUMINEUX ET DIODE ÉLECTROLUMINESCENTE

(43) Veröffentlichungstag der Anmeldung: 04.12.2019
(62) Teilanmeldung aus: 15180933.2
(73) Patentinhaber: Siemens Schweiz AG, 8047 Zürich (CH)
(72) Erfinder: AEBERSOLD, Hans, 8906 Bonstetten (CH)
(74) Vertreter: Siemens Patent Attorneys

(56) Entgegenhaltungen:
- CN-A- 103 596 346
- DE-A1- 102009 006 250
- DE-U1- 202014 009 738
- US-A1- 2010 328 085
- FORREST M. MIMS III: "How to Use LEDs to Detect Light | Make:", 8 January 2014 (2014-01-08), XP055627794, Retrieved from the Internet <URL:https://makezine.com/projects/make-36-boards/how-to-use-leds-to-detect-light/> [retrieved on 20191001]
- KUOCHUN TSENG ET AL: "Novel Silicon-Based LED Packaging Module With an Integrated Photosensing Element", IEEE PHOTONICS TECHNOLOGY LETTERS, IEEE, USA, vol. 25, no. 5, 1 March 2013 (2013-03-01), pages 515 - 518, XP011494233, ISSN: 1041-1135, DOI: 10.1109/LPT.2013.2244207

## Beschreibung

Die Erfindung betrifft eine optische Rauchdetektionseinheit für einen Gefahrenmelder, insbesondere für einen Rauchmelder. Die Rauchdetektionseinheit weist zumindest eine Leuchtdiode zum Aussenden von Licht auf. Die Leuchtdiode ist ein aus einem transparenten, vorzugsweise aus einem klaren Werkstoff hergestelltes LED-Gehäuse mit einem darin angeordneten LED-Chip sowie den LED-Chip kontaktierende, aus dem LED-Gehäuse herausgeführte Anschlusskontakte. Die Rauchdetektionseinheit umfasst zudem einen zumindest spektral auf ausgesandtes Licht empfindlichen Photoempfänger für die Rauchdetektion, wie z.B. eine Photodiode, sowie eine mit der Leuchtdiode und mit dem Photoempfänger verbundene Steuereinheit. Die Steuereinheit ist typischerweise ein Mikrocontroller. Sie ist zumindest zur elektrischen Ansteuerung der Leuchtdiode (zum Leuchten) sowie zur Bewertung eines vom Photoempfänger ausgegebenen Sensorsignals auf Brandkenngrössen hin vorgesehen. Die optische Rauchdetektionseinheit umfasst weiter einen spektral auf das ausgesandte Licht empfindlichen Photosensor. Die Steuereinheit ist zudem dazu eingerichtet, während der elektrischen Ansteuerung der Leuchtdiode zugleich eine elektrische Kenngrösse des Photosensors zu erfassen, um daraus eine Alterungsinformation der Leuchtdiode abzuleiten und auszugeben und/oder um daraus eine Abnahme des Lichtstroms der Leuchtdiode zu bestimmen und diese durch eine geänderte elektrische Ansteuerung der Leuchtdiode zu korrigieren.

Die jeweiligen Verarbeitungsschritte für die zeitliche Ansteuerung der beiden LED-Chips sowie die synchronisierte Erfassung und Auswertung des jeweiligen Photosensorsignals können durch geeignete, auf dem Mikrocontroller ausführbare Programmschritte realisiert sein. Die Leuchtdiode, der Photoempfänger sowie der Mikrocontroller sind vorzugsweise auf einem Schaltungsträger angeordnet und untereinander verschaltet.

Derartige Rauchdetektionseinheiten sind allgemein bekannt. Sie können - wie auch bei der vorliegenden Erfindung - Teil eines Streulichtrauchmelders in geschlossener oder offener Bauweise sein. In geschlossener Bauweise weist ein solcher Streulichtrauchmelder eine für zu detektierenden Rauch durchlässige, jedoch gegen direktes Umgebungslicht abgeschirmte optische Messkammer auf. Eine derartige Messkammer wird oft auch als Labyrinth bezeichnet. Streulichtrauchmelder der offenen Bauart weisen dagegen einen ausserhalb des Meldergehäuses im Freien liegenden Detektionsraum auf. Schliesslich können derartige Rauchdetektionseinheiten Teil eines Extinktionsrauchmelders sein, bei dem die Lichtschwächung durch anwesenden Rauch durch den Photoempfänger detektiert und auswertet wird.

Aus der veröffentlichten Patentanmeldung US 2010/0328085 A1 ist ein photoelektrischer Rauchmelder, insbesondere ein Ansaugrauchmelder bekannt, der eine Quelle für Strahlungsenergie und einen geschlossenen Regelkreis umfasst, der auf ein Rückkopplungssignal der Strahlungsenergie reagiert, um eine Ausgangscharakteristik der emittierten Strahlungsenergie einzustellen, und der eine Qualitätscharakteristik der emittierten Strahlungsenergie auswertet. Der Rückkopplungskreis und die Quelle können intermittierend aktiviert werden. Emittierte Strahlungsenergie wird auf eine Linse gerichtet. Das Rückkopplungssignal ist proportional zur Strahlungsenergie, die von der Linse reflektiert oder gestreut wird.

Bekannt ist auch, dass Leuchtdioden im Betrieb altern und im Laufe der Zeit eine verringerte Lichtleistung aufweisen. Im Gegensatz dazu zeigen Photosensoren, wie z.B. Photodioden, vergleichsweise kleine, vernachlässigbare Alterungserscheinungen. Es ist folglich die Lichtleistung zu überwachen, um im Fall einer zu geringen Lichtleistung für die Rauchdetektion eine Warnmeldung auszugeben. Alternativ kann die Ansteuerleistung oder die Pulsdauer für die Ansteuerung der Leuchtdiode erhöht werden, um die verringerte Lichtleistung bzw. den verringerten emittierten Lichtstrom zu korrigieren. Hierzu ist die Verwendung eines separaten Photosensors bekannt, der vorzugsweise direktes Licht von der Leuchtdiode empfängt und der Leuchtdiode gegenüberliegend angeordnet ist. Abhängig vom Photoempfängersignal erfolgt dann die Ausgabe der Warnmeldung und/oder es erfolgt eine Lichtleistungskompensation über dem Weg der elektrischen Ansteuerung der Leuchtdiode.

Weiterhin ist bekannt, dass sämtliche optoelektronischen Bauelemente in der Rauchdetektionseinheit mit der Zeit verschmutzen. Das bedeutet, dass die optische Sendeleistung der Leuchtdiode und die optische Detektionsempfindlichkeit des Photoempfängers für die Rauchdetektion sowie des separaten Photoempfängers für die Lichtleistungs- bzw. Lichtstromüberwachung mit zunehmender Verschmutzung und unabhängig von der Alterung dieser optoelektronischen Bauelemente abnehmen.

Schliesslich sind aus dem Stand der Technik Leuchtdioden, insbesondere ein-, zwei- oder mehrfarbige Leuchtdioden, bekannt, die einstückige Baueinheiten sind. Derartige Leuchtdiode weisen ein LED-Gehäuse, zumindest einen darin angeordneten LED-Chip für die jeweilige "Farbe" sowie den jeweilige LED-Chip kontaktierende, aus dem LED-Gehäuse herausgeführte Anschlusskontakte auf.

Davon ausgehend ist es eine Aufgabe der Erfindung, eine optische Rauchdetektionseinheit anzugeben, die über die Stand- und Betriebszeit hinweg zuverlässiger arbeitet.

Die Aufgabe wird mit den Merkmalen des Hauptanspruchs gelöst. Vorteilhafte Ausführungsformen der vorliegenden Erfindung sind in den abhängigen Ansprüchen angegeben. In den Ansprüchen 8 bis 10 sind ein geschlossener, ein offener und ein Extinktionsrauchmelder angegeben, die jeweils eine erfindungsgemässe Rauchdetektionseinheit aufweisen.

Erfindungsgemäss weist die Leuchtdiode den spektral auf das ausgesandte Licht empfindlichen Photosensor auf. Der Photosensor und der LED-Chip sind nebeneinander auf einem Chipträger der Leuchtdiode und im LED-Gehäuse angeordnet.

Die Steuereinheit ist somit dazu eingerichtet, vorzugsweise den durch den Photosensor fliessenden Photostrom als Mass für den emittierten Lichtstrom der angesteuerten Leuchtdiode zu erfassen. Sie ist ausserdem dazu eingerichtet, eine vom Grad der Abnahme des Photostroms abhängige Alterungsinformation der angesteuerten Leuchtdiode abzuleiten und auszugeben und/oder davon abhängig die elektrische Ansteuerung der angesteuerten Leuchtdiode zu verändern, um eine entsprechende Abnahme des emittierten Lichtstroms zu korrigieren.

Der Photosensor ist insbesondere im LED-Gehäuse aufgenommen. Insbesondere ist er optisch mit dem LED-Chip bzw. mit den LED-Chips gekoppelt. Dadurch gelangt ein Teil des vom LED-Chips bzw. von den LED-Chips ausgesandten Lichts mittelbar oder unmittelbar, wie z.B. durch Streuung oder Reflexion, zum Photosensor und ist dann durch diesen detektierbar.

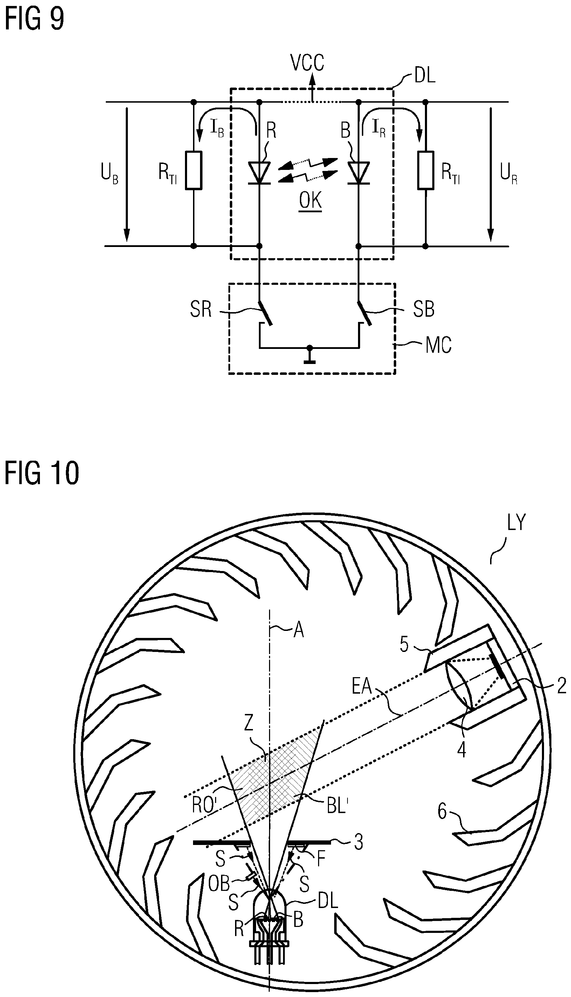

Anstelle des Photostroms kann auch eine von der Leuchtdiode erzeugte Photospannung als elektrische Kenngrösse erfasst werden. Hierzu wird parallel zur Leuchtdiode ein ohmscher Transimpedanzwiderstand geschaltet, der den durch die Leuchtdiode fliessenden Photostrom in eine dazu proportionale Photospannung umsetzt. Dabei wird die Leuchtdiode in ihrem Betrieb als Photodiode von dem Teil der dazu vorgesehenen Schaltungsanordnung (siehe FIG 9) freigeschaltet, der zur elektrischen Ansteuerung der Leuchtdiode zum Leuchten vorgesehen ist.

Der Grad der Abnahme des Photostroms kann durch Ermittlung der Differenz zwischen einem Nennstromwert für den Photostrom und einem aktuellen Ist-Stromwert des Photostroms erfolgen. Der Nennstromwert kann z.B. im Rahmen einer Typ- oder Serienprüfung der optischen Rauchdetektionseinheit ermittelt werden. Er kann auch ein Mittelwert von gemessenen Stromwerten am Anfang der Betriebszeit des Rauchmelders sein. Der so festgelegte Nennstromwert kann z.B. in einem Speicher der Steuereinheit, d.h. in einem nichtflüchtigen Speicher des Mikrocontrollers, hinterlegt werden. Die Steuereinheit kann dazu eingerichtet sein, wiederholt und insbesondere zyklisch einen aktuellen Ist-Stromwert des Photostroms zu erfassen und rechnerisch die Differenz aus dem hinterlegten Nennstromwert und dem aktuell erfassten Ist-Stromwert des Photostroms zu bilden. Diese Differenz aus den beiden Stromwerten entspricht dann dem Grad der Abnahme des Photostroms.

Die Alterungsinformation kann z.B. ein mehrstufiger Alterungsgrad sein oder eine binäre Alterungsinformation sein wie z.B. "nicht gealtert" oder "gealtert". Der Alterungsgrad kann z.B. durch einen Zahlen- oder Prozentwert, wie z.B. von 0% bis 100%, repräsentiert sein. Beispielsweise kann ein Prozentwert von 0 den Neuzustand und ein Prozentwert von 100 einen Zustand repräsentieren, bei dem eine sichere Rauchdetektion wegen zu geringem Streulicht nicht mehr möglich ist. Die Prozentwerte für den Neuzustand wie auch für den Zustand der nicht mehr sicheren Rauchdetektion können z.B. im Rahmen einer Typprüfung der Rauchdetektionseinheit bzw. des Rauchmelders messtechnisch ermittelt werden. Dazwischen liegende Prozentwerte können linear interpoliert sein. Bei einem vorgegebenen Wert, wie z.B. bei 50% oder 80%, ist dann eine entsprechende Warnmeldung ausgebbar, wie z.B. über einen angeschlossenen Melderbus des Rauchmelders, über Funk und/oder akustisch oder optisch am Rauchmelder selbst. Die Zuordnung zwischen erfasstem Photostrom des Photosensors zu dem beispielhaften Prozentbereich von 0% bis 100% kann mittels einer Zahlentabelle oder einer Kennlinie erfolgen, die zur späteren Alterungsbewertung durch den Mikrocontroller in einem elektronischen Speicher des Mikrocontrollers hinterlegt werden.

Die Steuereinheit kann dazu eingerichtet sein, den emittierten Lichtstrom der (zum Leuchten) angesteuerten Leuchtdiode mittels eines offenen oder geschlossenen Regelkreises an einen geforderten Nennlichtstrom für die Rauchdetektion nachzuführen. Der Lichtstrom kann z.B. durch eine Verlängerung der Pulslänge bei der elektrischen Ansteuerung der Leuchtdiode verändert werden, sodass auch die Lichtenergie pro Lichtpuls zunimmt. Alternativ oder zusätzlich kann auch der Ansteuerstrom und somit auch der Lichtstrom bzw. die Lichtleistung der Leuchtdiode erhöht werden. Im Sinne eines geschlossenen Regelkreises kann fortlaufend der aktuelle Lichtstrom ermittelt und durch Änderung in der elektrischen Ansteuerung der Leuchtdiode nachgeführt werden.

Der besondere Vorteil liegt darin, dass der LED-Chip und der Photosensor durch die Integration in einem gemeinsamen LED-Gehäuse keiner Verschmutzung unterliegen. Somit können durch die direkte optische Kopplung zwischen dem LED-Chip und dem Photosensor keine Verschmutzungspartikel in den optischen Kopplungspfad gelangen. Der Photoempfänger misst folglich über die Betriebszeit der Rauchdetektionseinheit immer den aktuellen Lichtstromwert bzw. die aktuelle Lichtleistung des LED-Chips. Hierzu reicht ein gewisses Streulicht vom LED-Chip, das unmittelbar oder über Reflektionen am LED-Gehäuse auf den Photosensor auftritt, zur möglichen messtechnischen Erfassung und Bewertung aus.

Durch die Integration in die einstückige Leuchtdiode ist kein externer Photosensor mehr erforderlich. Das vom Photosensor ausgegebene Sensorsignal kann z.B. über einen weiteren und aus dem LED-Gehäuse herausgeführten Anschlusskontakt messtechnisch erfasst werden. Der Photosensor kann bereits auch eine integrierte Messschaltung aufweisen und eingerichtet sein, den Versorgungsstrom des LED-Chips mit einem dem aktuell gemessenen Lichtstromwert entsprechenden Stromsignal zu modulieren. Dieses Signal kann dann durch eine Messschaltung ausserhalb der Leuchtdiode erfasst und ausgewertet werden. In diesem Fall ist ein weiterer Anschlusskontakt nicht erforderlich.

Nach einer Ausführungsform ist der Photosensor eine spektral auf das ausgesandte Licht des LED-Chips empfindliche Photodiode, insbesondere eine PIN-Photodiode. Die Photodiode kann auch eine integrierte elektronische Messverstärkerschaltung aufweisen.

Einer Ausführungsform zufolge weist die Leuchtdiode zwei vorzugsweise typgleiche LED-Chips auf, wie z.B. blauleuchtende oder infrarotleuchtende LED-Chips. Es ist (nur) ein erster der beiden LED-Chips zum Aussenden von einfarbigem Licht vorgesehen, während (nur) der andere zweite LED-Chip zum Betrieb als Photosensor vorgesehen ist. Die Steuereinheit ist dazu eingerichtet, (nur) den ersten LED-Chip elektrisch (zum Leuchten) anzusteuern und zugleich den durch den zweiten LED-Chip fliessenden Photostrom oder eine durch den zweiten LED-Chip erzeugte Photospannung zu erfassen, um daraus die Alterungsinformation des ersten LED-Chips abzuleiten und auszugeben. Die Steuereinheit kann alternativ oder zusätzlich dazu eingerichtet sein, daraus die Abnahme des Lichtstroms des ersten LED-Chips zu bestimmen und durch eine geänderte elektrische Ansteuerung des ersten LED-Chips zu korrigieren.

Der Erfindung liegt die Erkenntnis zugrunde, dass jede Leuchtdiode auch als Photodiode verwendet bzw. betrieben werden kann, wenn auch mit einem erheblich schlechteren Wirkungsgrad im Vergleich zu Photodioden, die speziell zu Detektionszwecken entwickelt worden sind. Dennoch reicht das durch den jeweils anderen LED-Chip empfangene reflektierte Licht zumeist aus, um zumindest qualitativ den Lichtstrom des elektrisch angesteuerten LED-Chips zu bestimmen.

Der Vorteil bei dieser Ausführungsform liegt in der einfachen Realisierung einer überwachten einfarbigen Leuchtdiode, indem zwei baugleiche LED-Chips im Rahmen der Herstellung nebeneinander auf einem gemeinsamen LED-Chipträger appliziert und dann mit den Anschlusskontakten kontaktiert werden.

Die LED-Chips sind vorzugsweise als Flächenstrahler ausgebildet. Mit "Flächenstrahler" ist hier gemeint, dass das Licht aus einer ebenen Fläche mit einer Lambert'schen Lichtverteilung abgestrahlt wird. Die Flächenstrahler können somit auch als Lambert-Strahler bezeichnet werden.

Die Steuereinheit ist in diesem Fall dazu eingerichtet, einen der LED-Chips elektrisch (zum Leuchten) anzusteuern und den anderen LED-Chip in eine Betriebsart als Photodiode zu schalten. Dies kann auch alternierend für beide LED-Chips erfolgen. Die Steuereinheit ist zudem dazu eingerichtet, den durch den anderen LED-Chip fliessenden Photostrom oder eine durch den anderen LED-Chip erzeugte Photospannung als elektrische Kenngrösse zu erfassen, um daraus die Alterungsinformation des jeweiligen angesteuerten LED-Chips abzuleiten und auszugeben. Die Steuereinheit kann alternativ oder zusätzlich dazu eingerichtet sein, daraus die Abnahme des Lichtstroms des jeweiligen angesteuerten LED-Chips zu bestimmen und durch eine geänderte elektrische Ansteuerung des jeweiligen angesteuerten LED-Chips zu korrigieren.

Die LED-Chips stammen üblicherweise aus einem Wafer mit einer Vielzahl in einem optoelektronischen Halbleiterprozess hergestellter LED-Chips. Ein solcher Wafer wird durch mechanische Trennprozesse, insbesondere durch Sägen oder Brechen, in die Vielzahl der LED-Chips zerlegt. Ein solches "nacktes" und für sich vollständig funktionsfähiges Bauteil wird auch als "ie" bezeichnet. Es weist daher eine typischerweise quadratische oder auch rechteckige Form auf. Ein dabei kaum verwertbarer Lichtanteil wird auch über die seitlichen Kanten eines derartigen LED-Chips ausgesandt. Genau dieser Anteil kann nun vorteilhaft zu Alterungsüberwachung verwendet werden.

Nach einer vorteilhaften Ausführungsform ist die Leuchtdiode eine Zweifarben-Leuchtdiode. Sie weist wiederum wie eingangs beschrieben einen ersten und zweiten LED-Chip zum Aussenden von Licht in einem ersten und in einem davon verschiedenen zweiten Wellenlängenbereich auf. Der Photosensor ist eine spektral auf das ausgesendete Licht empfindliche Photodiode, insbesondere eine PIN-Photodiode. Die Steuereinheit ist dazu eingerichtet ist, wahlweise einen der LED-Chips elektrisch (zum Leuchten) anzusteuern und zugleich den durch die Photodiode fliessenden Photostrom oder eine durch die Photodiode erzeugte Photospannung als elektrische Kenngrösse zu erfassen, um daraus die Alterungsinformation des jeweiligen angesteuerten LED-Chips abzuleiten und auszugeben. Alternativ oder zusätzlich ist die Steuereinheit dazu eingerichtet, daraus die Abnahme des Lichtstroms des jeweiligen angesteuerten LED-Chips zu bestimmen und diese durch eine geänderte elektrische Ansteuerung des jeweiligen angesteuerten LED-Chips zu korrigieren.

Durch die Verwendung einer spektral auf das ausgesandte Licht der beiden LED-Chips sensitiven Photodiode ist vorteilhaft eine sehr genaue Ermittlung des Alterungsgrads der beiden LED-Chips sowie deren Korrektur bzw. Kompensation möglich.

Ein weiterer Vorteil liegt in der kompakten Integration der Photodiode auf dem Chipträger zusammen mit den beiden benachbart angeordneten LED-Chips. Durch das Fehlen jeglicher Verschmutzungsmöglichkeit ist eine exakte Bestimmung der Alterung beider LED-Chips möglich.

Die Aufgabe der Erfindung wird weiterhin durch einen Streulichtrauchmelder gelöst, der ein Meldergehäuse und eine darin aufgenommene optische Messkammer mit zumindest einer Öffnung für den möglichen Durchtritt von zu detektierendem Rauch aufweist. In der Messkammer ist eine gegenüber Umgebungslicht abgeschirmte erfindungsgemässe Rauchdetektionseinheit aufgenommen. Der Photoempfänger ist mit zumindest einer Leuchtdiode in einer Vorwärts- und/oder Rückwärtsstreulichtanordnung angeordnet. Die Steuereinheit ist dazu eingerichtet, einen Brandalarm auszugeben, falls das vom Photoempfänger ausgegebene Sensorsignal einen Mindeststreulichtpegel überschreitet. Bei einer Vorwärtsstreulichtanordnung liegt der Winkel zwischen Leuchtdiode und dem Photoempfänger in einem Bereich von 20° bis 90°, insbesondere in einem Bereich von 30° bis 70°. Bei einer Rückwärtsstreulichtanordnung liegt dieser Winkel in einem Bereich von mehr als 90° bis 160°, insbesondere in einem Bereich von 110° bis 150°.

Weiterhin wird die Aufgabe durch einen offenen Streulichtrauchmelder mit einer erfindungsgemässen Rauchdetektionseinheit gelöst. Letztere ist in oder an einem Meldergehäuse des offenen Streulichtrauchmelders angeordnet, wobei sich ein für die Detektion von Streulicht vorgesehener Detektionsraum dann ausserhalb des Meldergehäuses befindet. Mit anderen Worten befinden sich zwischen der Leuchtdiode und dem im Freien liegenden Detektionsraum einerseits und zwischen dem Photoempfänger und dem im Freien liegenden Detektionsraum keine weiteren Teile des Meldergehäuses. Davon abgesehen kann eine transparente Abdeckung zum Schutz gegen Verschmutzung der Leuchtdiode und des Photoempfängers am Meldergehäuse vorhanden sein. Die Steuereinheit ist dazu eingerichtet, einen Brandalarm auszugeben, falls das vom Photoempfänger ausgegebene Sensorsignal einen Mindeststreulichtpegel überschreitet.

Die Aufgabe der Erfindung wird weiterhin durch einen Extinktionsrauchmelder gelöst, der ein Meldergehäuse mit zumindest einer Öffnung für den möglichen Durchtritt von zu detektierendem Rauch sowie eine im Meldergehäuse angeordnete, gegenüber Umgebungslicht abgeschirmte erfindungsgemässe Rauchdetektionseinheit aufweist. Der Photoempfänger ist der Leuchtdiode zur Detektion von direktem Licht gegenüberliegend angeordnet. Die Steuereinheit ist dazu eingerichtet, einen Brandalarm auszugeben, falls das vom Photoempfänger ausgegebene Sensorsignal einen Vergleichswert für eine maximal zulässige Lichtabschwächung unterschreitet.

Die Erfindung sowie vorteilhafte Ausführungen der vorliegenden Erfindung werden am Beispiel der nachfolgenden Figuren erläutert. Dabei zeigen:
- FIG 1: eine beispielhafte Leuchtdiode für eine erfindungsgemässe Rauchdetektionseinheit mit einem ersten LED-Chip sowie mit einem zweiten LED-Chip oder mit einer Photodiode zur Detektion eines Teils des vom zweiten LED-Chips ausgesandten Lichts,
- FIG 2: eine erste Ausführungsform mit einem einzigen LED-Chip und mit einer Photodiode,
- FIG 3: eine zweite Ausführungsform mit zwei LED-Chips,
- FIG 4: die erfindungsgemässe wechselweise Ansteuerung zweier LED-Chips und messtechnische Auswertung in symbolischer Darstellung,
- FIG 5: eine weitere Ausführungsform mit zwei nebeneinander angeordneten LED-Chips zur Emission und Detektion von jeweils ausgesandtem Kantenlicht,
- FIG 6: eine weitere Ausführungsform mit zwei LED-Chips und einer Photodiode zur Detektion jeweils eines Teils des von den LED-Chips ausgesandten Lichts gemäss der Erfindung,
- FIG 7,: ein Beispiel für die Lichtausbreitung und Reflexion
- FIG 8: in einem LED-Gehäuse von beispielhaft blauem und roten Licht sowie dessen Detektion durch den jeweils anderen LED-Chip,
- FIG 9: eine beispielhafte Schaltungsanordnung zur wechselweisen Ansteuerung sowie zur wechselweisen Auswertung zweier LED-Chips jeweils mittels eines Transimpedanzwandlers gemäss der Erfindung, und
- FIG 10: ein Beispiel für eine erfindungsgemässe Rauchdetektionseinheit für einen Streulichtrauchmelder mit einer Zweifarben-LED und mit einem Photoempfänger in einer Vorwärtsstreulichtanordnung.

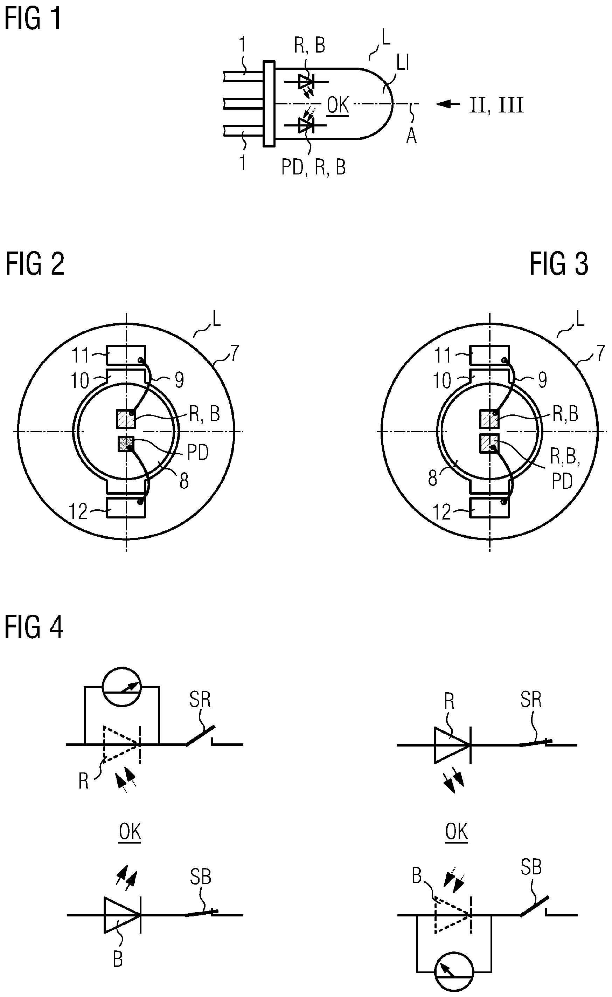

FIG 1 zeigt eine beispielhafte Leuchtdiode L für eine erfindungsgemässe Rauchdetektionseinheit mit einem ersten LED-Chip R, B sowie mit einem zweiten LED-Chip B, R oder alternativ mit einer Photodiode PD zur Detektion eines Teils des vom zweiten LED-Chips B, R ausgesandten Lichts. Das Bezugszeichen R deutet an, dass es sich vorzugsweise um einen rot- bzw. infrarotleuchtenden LED-Chip handelt, während das Bezugszeichen B andeutet, dass es sich vorzugsweise um einen blauleuchtenden LED-Chip handelt. Mit OK ist eine optische Kopplung bezeichnet. Diese steht symbolisch dafür, dass ein Teil des vom jeweiligen LED-Chip R, B, ausgesandten Lichts zum jeweils anderen LED-Chip B, R bzw. zur Photodiode PD gelangt, um dort detektiert werden zu können. Mit dem Bezugszeichen sind die Anschlusskontakte der Leuchtdiode L bezeichnet. Die gezeigte Leuchtdiode L weist weiter ein transparentes LED-Gehäuse auf, welches im Bereich der Lichtaustrittsseite eine optische Linse LI zur Fokussierung des ausgesandten Lichts ausbildet. Mit A ist die optische Achse bzw. die Hauptachse der Leuchtdiode L bezeichnet, entlang derer die Hauptausbreitung des ausgesandten Lichts erfolgt.

FIG 2 zeigt eine erste Ausführungsform mit einem einzigen LED-Chip R, B und mit einer Photodiode PD entlang der in FIG 1 gezeigten Blickrichtung II. Mit dem Bezugszeichen 7 sind ein LED-Gehäuse aus transparentem Kunststoff, mit 8 ein Chipträger und mit 9 Bonddrähte bezeichnet, die den LED-Chip R, B mit den aus dem LED-Gehäuse 7 geführten Anschlusskontakten 1 über entsprechende Kontaktierungsflächen 10, 11, 12 kontaktieren. Mit 10 ist eine gemeinsame Anschlusskontaktfläche für ein gemeinsames Spannungspotenzial bezeichnet und bildet nach aussen hin einen gemeinsamen Anschlusskontakt 1.

FIG 3 zeigt eine zweite Ausführungsform mit zwei LED-Chips R, B entlang der in FIG 1 gezeigten Blickrichtung III. Erfindungsgemäss handelt es sich bei den beiden LED-Chips R, B um typgleiche optoelektronische Bauelemente, die typischerweise aus einem gleichen Los stammen. Dabei ist bestimmungsgemäss ein erster der beiden LED-Chips R, B zum Aussenden von einfarbigem Licht vorgesehen, während der andere zweite LED-Chip R, B zum Betrieb als Photodiode vorgesehen. Hierzu ist eine mit den beiden LED-Chips R, B verbundene Steuereinheit dazu eingerichtet, (nur) den ersten LED-Chip R, B elektrisch anzusteuern und zugleich den durch den zweiten LED-Chip R, B fliessenden Photostrom oder eine durch den zweiten LED-Chip R, B erzeugte Photospannung zu erfassen, um daraus die Alterungsinformation des ersten LED-Chips R, B abzuleiten und auszugeben. Alternativ oder zusätzlich ist die Steuereinheit dazu eingerichtet, um daraus die Abnahme des Lichtstroms des ersten LED-Chips R, B zu bestimmen und diese durch eine geänderte elektrische Ansteuerung des ersten LED-Chips R, B zu korrigieren. Eine dazu geeignete Schaltungsanordnung ist im Beispiel der FIG 9 gezeigt.

FIG 4 zeigt die erfindungsgemässe wechselweise Ansteuerung zweier LED-Chips R, B der Leuchtdiode sowie die messtechnische Auswertung in symbolischer Darstellung. Im linken Teil der Figur ist der "blaue" LED-Chip B, symbolisiert durch einen geschlossenen Schalter SB, zum Aussenden von blauem Licht elektrisch angesteuert, während der "rote" LED-Chip R, symbolisiert durch einen geöffneten Schalter SR und durch ein Messgerät zu Erfassung einer elektrischen Kenngrösse des "roten" LED-Chips R, in einen Betrieb als Photodiode geschaltet ist und durch die optische Kopplung OK einen Teil des blauen Lichts detektiert. Im rechten Teil der Figur ist nun der "rote" LED-Chip R zum Aussenden von rotem Licht elektrisch angesteuert, während der "blaue" LED-Chip B in einen Betrieb als Photodiode geschaltet ist und durch die optische Kopplung OK einen Teil des roten Lichts detektiert. Dabei ist die Detektion von blauem Licht durch den "roten" LED-Chip R effizienter als die Detektion von rotem Licht durch den blauen LED-Chip B. Dies ist in der FIG 4 durch den kleineren Zeigerausschlag beim blauen LED-Chip B im Vergleich zum Zeigerausschlag beim roten LED-Chip R symbolisiert.

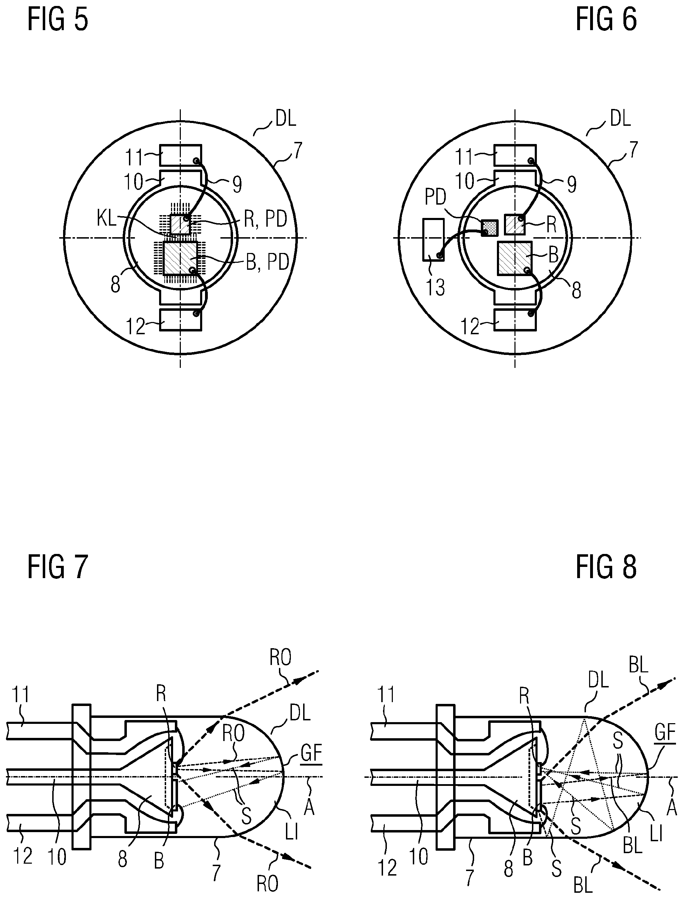

FIG 5 zeigt eine weitere Ausführungsform mit zwei nebeneinander angeordneten LED-Chips R, B zur Emission und Detektion von jeweils ausgesandtem Kantenlicht KL. Wie die FIG 5 zeigt, liegen sich zwei Kanten der beiden LED-Chips R, B gegenüber, so dass jeweils ausgesandtes Kantenlicht KL direkt seitlich beim jeweils gegenüberliegenden LED-Chip R, B einkoppeln kann. Bei der gezeigten Ausführungsform weist der "blaue" LED-Chip B im Vergleich zum "roten" LED-Chip R eine grössere optisch aktive Oberfläche von mehr als den Faktor 2,5 auf. Mit "optisch aktiv" sind die Teile der Oberfläche der LED-Chips gemeint, die bei Stromerregung Licht emittieren. Bereiche für die Kontaktierung der LED-Chips auf der Oberfläche, die z.B. zur Kontaktierung eines Bonddrahts bestimmt sind, gehören somit nicht dazu. Durch die grössere optisch aktive Oberfläche des "blauen" LED-Chips B lässt sich der schlechtere elektrooptische Wirkungsgrad bei der Lichterzeugung zumindest teilweise kompensieren.

FIG 6 zeigt eine weitere Ausführungsform mit zwei LED-Chips R, B und einer Photodiode PD zur Detektion jeweils eines Teils des von den LED-Chips R, B ausgesandten Lichts gemäss der Erfindung. Die Leuchtdiode ist somit eine Zweifarben-Leuchtdiode L. Die Photodiode PD ist spektral auf das ausgesendete zweifarbige Licht empfindlich. Die Photodiode PD ist eine PIN-Photodiode, wie z.B. eine Silizium-PIN-Photodiode, und vorzugsweise eine Silizium-PIN-Photodiode mit verbesserter Blauempfindlichkeit. Beide LED-Chips R, B und die als Chip ausgebildete bzw. als "Die" vorliegende Photodiode PD sind nebeneinander auf dem Chipträger 8 angeordnet.

Die Figuren 7 und 8 zeigen ein Beispiel für die Lichtausbreitung und Reflexion in einem LED-Gehäuse 7 von beispielhaft rotem und blauem Licht RO, BL sowie dessen Detektion durch den jeweils anderen LED-Chip R, B gemäss der Erfindung. In der FIG 7 ist der "rote" LED-Chip R zum Aussenden rotem Licht angesteuert. Die ausgesandten roten Lichtstrahlen RO werden durch die im LED-Gehäuse 7 ausgebildete optische Linse LI fokussiert. Ein Teil der Lichtstrahlen RO wird jedoch an der Grenzfläche GF zur aussenliegenden Umgebungsluft reflektiert und gelangt als Streulicht unter anderem auch zum "blauen" LED-Chip B. Mittels dieser optischen Kopplung ist Licht vom "roten" LED-Chips R durch den "blauen" LED-Chip B detektierbar. FIG 8 zeigt analog den Fall des Aussendens von blauem Licht und der Detektion eines Teils der reflektierten blauen Lichtstrahlen BL durch den "roten" LED-Chip R.

FIG 9 zeigt eine beispielhafte Schaltungsanordnung zur wechselweisen Ansteuerung sowie zur wechselweisen Auswertung zweier LED-Chips R, B jeweils mittels eines Transimpedanzwandlers R_{TI} gemäss der Erfindung. Im unteren Teil der FIG 9 ist eine als Mikrocontroller ausgebildete Steuereinheit MC dargestellt, welche dazu programmiert ist, wechselweise die beiden Schalter SR, SB zu schliessen und zu öffnen. Die beiden Schalter SR, SB sind üblicherweise Schalttransistoren. Sie sind im vorliegenden Beispiel im Mikrocontroller MC bereits integriert. Mit den beiden Schaltern SR, SB werden die beiden LED-Chips R, B wechselweise zur Lichtaussendung an eine Versorgungsspannung VCC geschaltet. Ein jeweils parallel zu einem LED-Chip R, B geschalteter ohmscher Widerstand R_{TI} ist dazu vorgesehen, einen jeweiligen erzeugten Photostrom I_{B}, I_{R} in der Betriebsart "Photodiode" in eine entsprechende Photospannung U_{B}, U_{R} umzuwandeln. Der Ohmwert der beiden Widerstände R_{TI} ist dabei um ein Vielfaches grösser als der Innenwiderstand der LED-Chips R, B in Vorwärtsrichtung. Die nun vorliegenden Photospannungen U_{B}, U_{R} können dabei besonders einfach durch einen A/D-Umsetzer erfasst und durch den Mikrocontroller MC ausgewertet werden. Die A/D-Umsetzer können auch im Mikrocontroller MC integriert sein.

FIG 10 zeigt abschliessend ein Beispiel für eine erfindungsgemässe Rauchdetektionseinheit für einen Streulichtrauchmelder. Der Melder weist eine Zweifarben-Leuchtdiode DL und einen Photoempfänger 2 mit vorgeschalteter Linse 4 in einer Vorwärtsstreulichtanordnung auf. Mit LY ist eine optische Messkammer bezeichnet, die für zu detektierenden Rauch durchlässig und gegenüber direktem Umgebungslicht abgeschirmt ist. Erreicht wird dies durch eine geeignete Anordnung von Lamellen 6 der Messkammer LY. Mit A ist die optische Achse der Leuchtdiode DL und mit EA die optische Empfangsachse des Photoempfängers 2 bezeichnet. Beide Achsen A, EA bilden beispielhaft einen Vorwärtsstreulichtwinkel von etwa 60°. Mit Z ist ein Streulichtzentrum bezeichnet. Ein Teil des Streulichts von zu detektierenden Partikeln, die von der Leuchtdiode DL in diesem Streulichtbereich bzw. Streulichtvolumen Z beleuchtet werden, gelangen schliesslich zum Photoempfänger 2. Um zu vermeiden, dass direktes Licht von der Leuchtdiode DL zum Photoempfänger 2 gelangt, sind zusätzlich Blenden 3, 5 vorgesehen. Mit RO' und BL' sind ausgesandte Lichtbündel bezeichnet, welche die Blende 3 der Leuchtdiode DL passieren. Gemäss der Erfindung kann zwischen der Leuchtdiode DL und der Blende 3 ein Rückstreuobjekt OB oder an der Blende eine reflektierende Schicht F angebracht werden, so dass ein Teil des ausgesandten Lichtbündels RO, BL wieder in Richtung zur Leuchtdiode DL reflektiert wird. Ein Teil dieses Streulichts S gelangt dann zum jeweiligen, nicht angesteuerten LED-Chip R, B. Eine an diesem LED-Chip R, B erzeugte Photospannung kann dann über die Anschlusskontakte 1 der Leuchtdiode DL erfasst und ausgewertet werden.

### Bezugszeichenliste

- 1, 10-13: Anschlusskontakte
- 2: Photosensor, Photodiode, Silizium-PIN-Photodiode
- 3: Blende, Lochblende
- 4: Photoempfängerlinse
- 5: Photoempfänger-Blende
- 6: Lamelle, Lichtabschirmelement
- 7: Gehäuse, LED-Gehäuse, Leuchtdiodengehäuse
- 8: LED-Chipträger, Träger, Trägerplatte
- 9: Bonddrähte

- A: optische Achse, optische Sendeachse
- B: blauer LED-Chip
- BL: blaues Lichtbündel
- BL': passierendes blaues Lichtbündel
- DL: Zweifarben-Leuchtdiode, DUAL-LED
- EA: optische Achse, optische Empfangsachse
- F: reflektierende Schicht, Farbschicht
- GF: optische Grenzfläche
- I_{R}, T_{B}: Photostrom
- KL: Kantenlicht
- L: Leuchtdiode, LED
- LI: optische Linse
- LY: optische Messkammer, Labyrinth
- MC: Steuereinheit, Mikrocontroller
- OB: Rückstreuobjekt
- OK: optische Kopplung
- PD: Photosensorchip, Photodiode
- R: roter LED-Chip
- RO: rotes Lichtbündel
- RO': passierendes rotes Lichtbündel
- R_{TI}: Widerstand, Transimpedanzwandler
- S: rückgestreutes Licht
- SR, SB: ansteuerbarer Schalter, Transistor
- U_{R}, U_{B}: Photospannung
- VCC: Versorgungsspannung
- Z: Streulichtzentrum, Messvolumen

## Patentansprüche

1. Optische Rauchdetektionseinheit für einen Gefahrenmelder, insbesondere für einen Rauchmelder, welche zumindest aufweist
- eine Leuchtdiode (L) zum Aussenden von Licht, wobei die Leuchtdiode (L) ein aus einem transparenten, vorzugsweise aus einem klaren Werkstoff hergestelltes LED-Gehäuse (7) mit einem darin angeordneten LED-Chip (R, B) sowie den LED-Chip (R, B) kontaktierende, aus dem LED-Gehäuse (7) herausgeführte Anschlusskontakte (1) umfasst,
- einen zumindest spektral auf ausgesandtes Licht empfindlichen Photoempfänger (2) für die Rauchdetektion,
- eine mit der Leuchtdiode (L) und mit dem Photoempfänger (2) verbundene Steuereinheit (MC) zur elektrischen Ansteuerung der Leuchtdiode und zur Bewertung eines vom Photoempfänger (2) ausgegebenen Sensorsignals auf Brandkenngrössen hin,
- einen spektral auf das ausgesandte Licht empfindlichen Photosensor (PD),
- wobei die Steuereinheit (MC) dazu eingerichtet ist, während der elektrischen Ansteuerung der Leuchtdiode (L) zugleich eine elektrische Kenngrösse des Photosensors (PD) zu erfassen, um daraus eine Alterungsinformation der Leuchtdiode (L) abzuleiten und auszugeben und/oder um daraus eine Abnahme des Lichtstroms der Leuchtdiode (L) zu bestimmen und diese durch eine geänderte elektrische Ansteuerung der Leuchtdiode (L) zu korrigieren,
**dadurch gekennzeichnet,**
- **dass** die Leuchtdiode (L) eine einstückige Baueinheit ist und den spektral auf das ausgesandte Licht empfindlichen Photosensor (PD) aufweist, und
- **dass** der Photosensor (PD) und der LED-Chip (R, B) nebeneinander auf einem Chipträger (8) der Leuchtdiode (L) und im LED-Gehäuse (7) angeordnet sind.

2. Rauchdetektionseinheit nach Anspruch 1, wobei der Photosensor (PD) eine spektral auf das ausgesandte Licht empfindliche Photodiode, insbesondere eine PIN-Photodiode ist.

3. Rauchdetektionseinheit nach Anspruch 1, wobei die Leuchtdiode (L) zwei vorzugsweise typgleiche LED-Chips (R, B) aufweist, wobei ein erster der beiden LED-Chips (R, B) zum Aussenden von einfarbigem Licht vorgesehen ist, während der andere zweite LED-Chip (R, B) zum Betrieb als Photodiode (PD) vorgesehen ist, wobei die Steuereinheit (MC) dazu eingerichtet ist, den ersten LED-Chip (R, B) elektrisch anzusteuern und zugleich den durch den zweiten LED-Chip (R, B) fliessenden Photostrom (I_{R}, I_{B}) oder eine durch den zweiten LED-Chip (R, B) erzeugte Photospannung (U_{R}, U_{B}) zu erfassen, um daraus die Alterungsinformation des ersten LED-Chips (R, B) abzuleiten und auszugeben und/oder um daraus die Abnahme des Lichtstroms des ersten LED-Chips (R, B) zu bestimmen und diese durch eine geänderte elektrische Ansteuerung des ersten LED-Chips (R, B) zu korrigieren.

4. Rauchdetektionseinheit nach Anspruch 3, wobei die zwei LED-Chips (R, B) nebeneinander auf einem Chipträger (8) der Leuchtdiode (D, DL) angeordnet sind, wobei eine Kante eines LED-Chips (R, B) einer Kante des anderen LED-Chips (B, R) gegenüberliegt, sodass seitlich ausgesendetes Kantenlicht (KL) eines LED-Chips (R, B) optisch seitlich in den anderen LED-Chip (B, R) einkoppelt.

5. Rauchdetektionseinheit nach Anspruch 1, wobei die Leuchtdiode (L) eine Zweifarben-Leuchtdiode (DL) ist, wobei die Zweifarben-Leuchtdiode (DL) einen ersten und zweiten LED-Chip (R, B) zum Aussenden von Licht in einem ersten und in einem davon verschiedenen zweiten Wellenlängenbereich aufweist, wobei der Photosensor (PD) eine spektral auf das ausgesendete Licht empfindliche Photodiode, insbesondere eine PIN-Photodiode ist, und wobei die Steuereinheit (MC) dazu eingerichtet ist, wahlweise einen der LED-Chips (R, B) elektrisch anzusteuern und zugleich den durch die Photodiode (PD) fliessenden Photostrom (I_{R}, I_{B}) oder eine an der Photodiode (PD) erzeugte Photospannung (U_{R}, U_{B}) als elektrische Kenngrösse zu erfassen, um daraus die Alterungsinformation des jeweiligen angesteuerten LED-Chips (R, B) abzuleiten und auszugeben und/oder um daraus die Abnahme des Lichtstroms des jeweiligen angesteuerten LED-Chips (R, B) zu bestimmen und diese durch eine geänderte elektrische Ansteuerung des jeweiligen angesteuerten LED-Chips (R, B) zu korrigieren.

6. Rauchdetektionseinheit nach einem der vorherigen Ansprüche, wobei zumindest einer der LED-Chips (R, B) zum Aussenden von Licht mit einer Wellenlänge im Bereich von 665 nm bis 1000 nm und/oder zum Aussenden von Licht mit einer Wellenlänge im Bereich von 350 nm bis 500 nm ausgebildet ist.

7. Rauchdetektionseinheit nach einem der vorherigen Ansprüche, wobei die Leuchtdiode (D, DL) ein Standardkunststoffgehäuse mit einem 3 mm- oder 5 mm-Durchmesser aufweist oder wobei die Leuchtdiode (D, DL) ein SMD-Bauelement für die Oberflächenmontage auf einem Schaltungsträger ist.

8. Streulichtrauchmelder, welcher ein Meldergehäuse und eine darin aufgenommene optische Messkammer (LY) mit zumindest einer Öffnung für den möglichen Durchtritt von zu detektierendem Rauch aufweist, wobei in der Messkammer (LY) eine gegenüber Umgebungslicht abgeschirmte Rauchdetektionseinheit nach einem der vorherigen Ansprüche 1 bis 7 aufgenommen ist, wobei der Photoempfänger (2) mit zumindest einer Leuchtdiode (L, DL) in einer Vorwärts- und/oder Rückwärtsstreulichtanordnung angeordnet ist und wobei die Steuereinheit (MC) dazu eingerichtet ist, einen Brandalarm auszugeben, falls das vom Photoempfänger (2) ausgegebene Sensorsignal einen Mindeststreulichtpegel überschreitet.

9. Offener Streulichtrauchmelder, mit einer Rauchdetektionseinheit nach einem der vorherigen Ansprüche 1 bis 7, wobei die Rauchdetektionseinheit in einem Meldergehäuse des offenen Streulichtrauchmelders angeordnet ist, wobei sich ein für die Detektion von Streulicht vorgesehener Detektionsraum ausserhalb des Meldergehäuses befindet und wobei die Steuereinheit (MC) dazu eingerichtet ist, einen Brandalarm auszugeben, falls das vom Photoempfänger (2) ausgegebene Sensorsignal einen Mindeststreulichtpegel überschreitet.

10. Extinktionsrauchmelder, mit einem Meldergehäuse mit zumindest einer Öffnung für den möglichen Durchtritt von zu detektierendem Rauch sowie eine im Meldergehäuse angeordnete, gegenüber Umgebungslicht abgeschirmte Rauchdetektionseinheit nach einem der vorherigen Ansprüche 1 bis 7, wobei der Photoempfänger (2) der Leuchtdiode (L, DL) zur Detektion von direktem Licht gegenüberliegend angeordnet ist und wobei die Steuereinheit (MC) dazu eingerichtet ist, einen Brandalarm auszugeben, falls das vom Photoempfänger (2) ausgegebene Sensorsignal einen Vergleichswert für eine maximal zulässige Lichtabschwächung unterschreitet.

## Claims

1. Optical smoke detection unit for a danger detector, in particular for a smoke detector, which comprises at least
- one light-emitting diode (L) for emitting light, wherein the light-emitting diode (L) comprises an LED housing (7) produced from a transparent material, preferably from a clear material, with an LED chip (R, B) arranged therein and terminal contacts (1) in contact with the LED chip (R, B) and leading out of the LED housing (7),
- a photoreceiver (2) which is at least spectrally sensitive to emitted light for the smoke detection,
- a control unit (MC) which is connected to the light-emitting diode (L) and to the photoreceiver (2) for the electrical activation of the light-emitting diode and for evaluating a sensor signal emitted by the photoreceiver (2) relative to fire parameters,
- a photosensor (PD) which is spectrally sensitive to the emitted light,
- wherein, during the electrical activation of the light-emitting diode (L), the control unit (MC) is designed at the same time to detect an electrical parameter of the photosensor (PD), in order to derive therefrom and to emit ageing information of the light-emitting diode (L) and/or in order to determine therefrom a reduction of the light flux of the light-emitting diode (L) and to correct this by changing the electrical activation of the light-emitting diode (L),
**characterised in that**
- the light-emitting diode (L) is an integral structural unit and comprises the photosensor (PD) which is spectrally sensitive to the emitted light, and
- the photosensor (PD) and the LED chip (R, B) are arranged adjacent to one another on a chip support (8) of the light-emitting diode (L) and in the LED housing (7).

2. Smoke detection unit according to claim 1, wherein the photosensor (PD) is a photodiode which is spectrally sensitive to the emitted light, in particular a PIN photodiode.

3. Smoke detection unit according to claim 1, wherein the light-emitting diode (L) has two LED chips (R, B), preferably of the same type, wherein a first of the two LED chips (R, B) is provided for emitting a single-color light, while the other second LED chip (R, B) is provided for operating as a photodiode (PD), wherein the control unit (MC) is designed to activate the first LED chip (R, B) electrically and at the same time to detect the photocurrent (I_{R}, I_{B}) flowing through the second LED chip (R, B) or a photovoltage (U_{R}, U_{B}) produced by the second LED chip (R, B), in order to derive therefrom and to emit ageing information of the first LED chip (R, B) and/or to determine therefrom the reduction of the light flux of the first LED chip (R, B) and to correct this by changing the electrical activation of the first LED chip (R, B).

4. Smoke detection unit according to claim 3, wherein the two LED chips (R, B) are arranged adjacent to one another on a chip support (8) of the light-emitting diode (D, DL), wherein one edge of an LED chip (R, B) opposes an edge of the other LED chip (B, R) so that edge light (KL) of one LED chip (R, B) emitted at the side is optically coupled into the other LED chip (B, R) at the side.

5. Smoke detection unit according to claim 1, wherein the light-emitting diode (L) is a two-colour light-emitting diode (DL), wherein the two-colour light-emitting diode (DL) has a first and a second LED chip (R, B) for emitting light in a first and in a second wavelength range which is different therefrom,
wherein the photosensor (PD) is a photodiode which is spectrally sensitive to the emitted light, in particular a PIN photodiode, and wherein the control unit (MC) is designed to activate optionally one of the LED chips (R, B) electrically and at the same time to detect the photocurrent (I_{R}, I_{B}) flowing through the photodiode (PD) or a photovoltage (U_{R}, U_{B}) produced on the photodiode (PD) as an electrical parameter, in order to derive therefrom and to emit the ageing information of the respectively activated LED chip (R, B) and/or in order to determine therefrom the reduction of the light flux of the respectively activated LED chip (R, B) and to correct this by changing the electrical activation of the respectively activated LED chip (R, B).

6. Smoke detection unit according to one of the preceding claims, wherein at least one of the LED chips (R, B) is configured for emitting light in a wavelength range of 665 nm to 1000 nm and/or for emitting light in a wavelength range of 350 nm to 500 nm.

7. Smoke detection unit according to one of the preceding claims, wherein the light-emitting diode (D, DL) has a standard plastics housing with a 3 mm or 5 mm diameter or wherein the light-emitting diode (D, DL) is an SMD component for surface-mounting on a circuit support.

8. Scattered light smoke detector which comprises a detector housing and an optical measuring chamber (LY) received therein with at least one opening for the possible passage of smoke to be detected, wherein a smoke detection unit, according to one of the preceding claims 1 to 7, which is shielded against ambient light is received in the measuring chamber (LY), wherein the photoreceiver (2) is arranged with at least one light-emitting diode (L, DL) in a forward-scattered and/or back-scattered light arrangement and wherein the control unit (MC) is designed to emit a fire alarm if the sensor signal emitted by the photoreceiver (2) exceeds a minimum scattered light level.

9. Open scattered light smoke detector, comprising a smoke detection unit according to one of the preceding claims 1 to 7, wherein the smoke detection unit is arranged in a detector housing of the open scattered light smoke detector, wherein a detection chamber provided for the detection of scattered light is located outside the detector housing and wherein the control unit (MC) is designed to emit a fire alarm if the sensor signal emitted by the photoreceiver (2) exceeds a minimum scattered light level.

10. Light extinction smoke detector comprising a detector housing with at least one opening for the possible passage of smoke to be detected and a smoke detection unit, which is arranged in the detector housing and shielded relative to ambient light, according to one of the preceding claims 1 to 7, wherein the photoreceiver (2) is arranged opposite the light-emitting diode (L, DL) for detecting direct light and wherein the control unit (MC) is designed to emit a fire alarm if the sensor signal emitted by the photoreceiver (2) falls below a comparison value for a maximum permitted light attenuation.

## Revendications

1. Unité de détection de fumée optique pour un détecteur de danger, en particulier pour un détecteur de fumée, qui présente au moins
- une diode électroluminescente (L) destinée à émettre une lumière, dans laquelle la diode électroluminescente (L) comprend un boîtier de LED (7) transparent et fabriqué de préférence à partir d'un matériau clair avec une puce LED (R, B) disposée à l'intérieur de celui-ci ainsi que des contacts de raccordement (1) entrant en contact avec la puce LED (R, B) et sortis du boîtier de LED (7),
- un photorécepteur (2) sensible au moins sur le plan spectral à la lumière émise pour la détection de fumée,
- une unité de commande (MC) reliée à la diode électroluminescente (L) et au photorécepteur (2) destinée à la commande électrique de la diode électroluminescente et destinée à l'évaluation d'un signal de capteur émis par le photorécepteur (2) en fonction de grandeurs caractéristiques de combustion,
- un photocapteur (PD) sensible sur le plan spectral à la lumière émise,
- dans laquelle l'unité de commande (MC) est configurée pour acquérir pendant la commande électrique de la diode électroluminescente (L) en même temps une grandeur caractéristique électrique du capteur (PD) pour déduire et émettre à partir de celle-ci une information sur le vieillissement de la diode électroluminescente (L) et/ou pour déterminer à partir de celle-ci une baisse du flux de lumière de la diode électroluminescente (L) et corriger celle-ci par le biais d'une commande électrique modifiée de la diode électroluminescente (L),
**caractérisée en ce**
- **que** la diode électroluminescente (L) est une unité modulaire d'un seul tenant et présente le photocapteur (PD) sensible sur le plan spectral à la lumière émise, et
- **que** le photocapteur (PD) et la puce LED (R, B) sont disposés l'un à côté de l'autre sur un support de puces (8) de la diode électroluminescente (L) et dans le boîtier de LED (7).

2. Unité de détection de fumée selon la revendication 1, dans laquelle le photocapteur (PD) est une photodiode sensible sur le plan spectral à la lumière émise, en particulier une photodiode PIN.

3. Unité de détection de fumée selon la revendication 1, dans laquelle la diode électroluminescente (L) présente deux puces LED (R, B) de préférence de type similaire, dans laquelle une première des deux puces LED (R, B) est prévue pour l'émission de lumière monochrome pendant que l'autre seconde puce LED (R, B) est prévue pour l'exploitation en tant que photodiode (PD), dans laquelle l'unité de commande (MC) est configurée pour commander électriquement la première puce LED (R, B) et acquérir en même temps le flux de lumière (I_{R}, I_{B}) s'écoulant à travers la seconde puce LED (R, B) ou une tension lumineuse (U_{R}, U_{B}) générée par le biais de la seconde puce LED (R, B) pour déduire et émettre à partir de celle-ci l'information sur le vieillissement de la première puce LED (R, B) et/ou pour déterminer à partir de celle-ci la baisse du flux de lumière de la première puce LED (R, B) et corriger celle-ci par le biais d'une commande électrique modifiée de la première puce LED (R, B).

4. Unité de détection de fumée selon la revendication 3, dans laquelle les deux puces LED (R, B) sont disposées l'une à côté de l'autre sur un support de puces (8) de la diode électroluminescente (D, DL), dans laquelle un bord d'une puce LED (R, B) est opposé à un bord de l'autre puce LED (B, R), de sorte qu'une lumière de bord (KL) émise latéralement d'une puce LED (R, B) se couple de manière optique latéralement dans l'autre puce LED (B, R).

5. Unité de détection de fumée selon la revendication 1, dans laquelle la diode électroluminescente (L) est une diode électroluminescente bicolore (DL), dans laquelle la diode électroluminescente bicolore (DL) présente une première et une seconde puce LED (R, B) destinées à l'émission de lumière dans une première et dans une seconde plage de longueurs d'onde différente de celle-ci, dans laquelle le photocapteur (PD) est une photodiode sensible sur le plan spectral à la lumière émise, en particulier une photodiode PIN, et dans laquelle l'unité de commande (MC) est configurée pour commander électriquement au choix une des puces LED (R, B) et pour acquérir en même temps le flux de lumière (I_{R}, I_{B}) s'écoulant à travers la photodiode (PD) ou une tension photovoltaïque (U_{R}, U_{B}) générée au niveau de la photodiode (PD) en tant que grandeur caractéristique électrique pour déduire et émettre à partir de celle-ci l'information sur le vieillissement de la puce LED (R, B) commandée respective et/ou pour déterminer à partir de celle-ci la baisse du flux de lumière de la puce LED (R, B) commandée respective et pour corriger celle-ci par le biais d'une commande électrique modifiée de la puce LED (R, B) commandée respective.

6. Unité de détection de fumée selon l'une quelconque des revendications précédentes, dans laquelle au moins une des puces LED (R, B) est réalisée pour l'émission de lumière avec une longueur d'onde dans la plage de 665 nm à 1 000 nm et/ou pour l'émission de lumière avec une longueur d'onde dans la plage de 350 nm à 500 nm.

7. Unité de détection de fumée selon l'une quelconque des revendications précédentes, dans laquelle la diode électroluminescente (D, DL) présente un boîtier en matière plastique standard avec un diamètre de 3 mm ou 5 mm ou dans laquelle la diode électroluminescente (D, DL) est un composant CMS pour le montage en surface sur un support de circuit.

8. Détecteur de fumée à lumière diffuse, qui présente un boîtier de détecteur et une chambre de mesure optique (LY) logée dans celui-ci avec au moins une ouverture pour le passage possible de fumée à détecter, dans lequel une unité de détection de fumée selon l'une quelconque des revendications 1 à 7 protégée par rapport à la lumière ambiante est logée dans la chambre de mesure (LY), dans laquelle le photorécepteur (2) est disposé avec au moins une diode électroluminescente (L, DL) dans un agencement de lumière diffuse vers l'avant et/ou vers l'arrière et dans lequel l'unité de commande (MC) est configurée pour émettre une alarme incendie dans le cas où le signal de capteur émis par le photorécepteur (2) est supérieur à un seuil de lumière diffuse minimal.

9. Détecteur de fumée à lumière diffuse ouvert, avec une unité de détection de fumée selon l'une quelconque des revendications 1 à 7, dans lequel l'unité de détection de fumée est disposée dans un boîtier de détecteur du détecteur de fumée à lumière diffuse, dans lequel un espace de détection prévu pour la détection de lumière diffuse se trouve à l'extérieur du boîtier de détecteur et dans lequel l'unité de commande (MC) est configurée pour émettre une alarme incendie dans le cas où le signal de détecteur émis par le photorécepteur (2) est supérieur à un seuil de lumière diffuse minimal.

10. Détecteur de fumée à extinction, avec un boîtier de détecteur avec au moins une ouverture pour le passage possible de fumée à détecter ainsi qu'une unité de détection de fumée selon l'une quelconque des revendications 1 à 7 protégée par rapport à la lumière ambiante et disposée dans le boîtier de détecteur, dans lequel le photorécepteur (2) est disposé en face de la diode électroluminescente (L, DL) pour la détection de lumière directe et dans lequel l'unité de commande (MC) est configurée pour émettre une alarme incendie dans le cas où le signal de capteur émis par le photorécepteur (2) est inférieur à une valeur de comparaison pour une baisse de lumière maximale admissible.
